# EUROPEAN PATENT SPECIFICATION

(11) **EP 1 751 856 B1**
(45) Date of publication and mention of the grant of the patent: **14.01.2009**
(21) Application number: 05744247.7
(22) Date of filing: 30.05.2005
(51) Int. Cl.: H03F 3/217, H04J 3/16

(54) **MULTI-CHANNEL PULSE MODULATOR SYSTEM**
MEHRKANALIGES IMPULSMODULATORSYSTEM
SYSTÈME MODULATEUR D'IMPULSIONS MULTICANAUX

(30) Priority: 28.05.2004 WO PCT/DK2004/000376
(43) Date of publication of application: 14.02.2007
(73) Proprietor: The TC Group A/S, 8240 Risskov (DK)
(72) Inventor: PEDERSEN, Kim, Rishøj, DK-8250 Egå (DK); ARKNÆS-PEDERSEN, Lars, DK-8260 Viby J (DK)
(74) Representative: Olesen, Kaj
(86) International application number: PCT/DK2005/000358
(87) International publication number: WO 2005/117382

(56) References cited:
- US-A- 4 345 323
- US-A- 4 488 121
- US-A- 4 703 471
- US-A1- 2002 097 085
- US-B1- 6 552 607
- FLOROS A C ET AL: "A novel and efficient PCM to PWM converter for digital audio amplifiers" ELECTRONICS, CIRCUITS AND SYSTEMS, 1999. PROCEEDINGS OF ICECS '99. THE 6TH IEEE INTERNATIONAL CONFERENCE ON PAFOS, CYPRUS 5-8 SEPT. 1999, PISCATAWAY, NJ, USA,IEEE, US, vol. 1, 5 September 1999 (1999-09-05), pages 165-168, XP010361459 ISBN: 0-7803-5682-9
- PATENT ABSTRACTS OF JAPAN vol. 010, no. 379 (E-465), 18 December 1986 (1986-12-18) & JP 61 171244 A (NIPPON SIGNAL CO LTD:THE), 1 August 1986 (1986-08-01)
- PATENT ABSTRACTS OF JAPAN vol. 004, no. 130 (E-025), 12 September 1980 (1980-09-12) & JP 55 082596 A (SONY CORP), 21 June 1980 (1980-06-21)

## Description

### Field of the invention

The invention relates to multi-channel pulse modulators. Such modulators are known from US6552607,US4488121, and JP61171244.

### Summary of the invention

The present invention provides a multi-channel pulse modulator system comprising a pulse modulator circuit (PMC),
wherein said pulse modulator circuit (PMC) comprises an N-channel pulse width modulator (PWMS1, PWMS2,..PWMS6) for modulating an N-channel input signal,
wherein the modulator output is multiplexed and output from the pulse modulator circuit (PMC) by means of L output connections (OP1, OPL) of the pulse modulator circuit (PMC) and where L is less than the number of modulator channels N.

According to the invention an advantageous interfacing has been established between the modulator circuit and the switching stage in the sense that a multi-channel, e.g. N-channel signal, is modulated into an N or N set of parallel signals by the modular of the modulator circuit and the modulated signal may be encoded or converted into a signal representation, which may be output from the modulator circuit in a small-level signal by means of a number of output connections L, e.g. L output pins, which is less than the number of modulated channels. In this way, an advantageous export of modulated signals may be obtained by a reduced number of pins of the modulator circuit and by means of small-level signals. L is at least one according to the invention. Thus, a complete multi-channel pulse, e.g. an N-channel modulated signal may be transmitted as a one channel by e.g. ultimately one single output connection or e.g. as one channel by e.g. two output connections forming a differential output connection of the circuit. Numerous other configurations of the output connection may be applied within the scope of the invention.

This advantage is in particular advantageous in relation to a number of modulated small-level signal channels, which must be fed to a switched high-level output stage.

When said multi-channel pulse modulation system further comprises a switched output stage SWOS,
wherein said pulse modulator circuit PMC comprises an N-channel modulator PWMS1, PWMS2,..PWMS6; PM,
wherein the modulator output is interfaced from the pulse modulator circuit PMC to the switching output stage SWOS by means of L output connections, e.g. output pins OP1, OPL, of the modulator circuit PMC and where L is less than the number of modulator channels N, an advantageous embodiment of the present invention is obtained.

When the L output connections (OP1, OPL) outputs an M-channel signal where M is less than N,
wherein said M-channel signal is established by a pulse signal combiner (PSC),
wherein said pulse signal combiner (PSC) combines at least one of said M-channel signals into a non-coincident pulse modulated signal (202, 203) representing at least a subset of an N-channel pulse modulated signal established by said N-channel modulator (PWMS1, PWMS2,..PWMS6; PM), an advantageous embodiment of the present invention is obtained.

When the number of output channels (OC1, OC2, OC3, ..OCN) of the switching output stage (SWOS) is N, an advantageous embodiment of the present invention is obtained.

When said pulse signal combiner (PSC) combines said N-channel pulse modulated signal by an initial establishment of said N-channel pulse signal of non-coincident pulses and whereby said non-coincident pulses subsequently are combined into said M-channel signal, an advantageous embodiment of the present invention is obtained.

A very interesting feature of the signal combining and signal splitting according to the invention is that cross-talk in the multi-channel output stage may be minimized due to the fact that the pulses transmitted over each of the M-channels by nature are non-coincident, thereby invoking that none of the output stages addressed by the M-channel switches at the same time unless a further signal processing occurs during the signal splitting and distributing to the N-channels at the receiving end.

When said M-channel output comprises a sequence of analog pulses, and whereby said sequence of analog pulses defines the pulses of an N-channel pulse modulated signal, an advantageous embodiment of the present invention is obtained.

When said pulse modulator circuit comprises a pulse modulator chip (PMC), an advantageous embodiment of the present invention is obtained.

According to a preferred embodiment of the invention the pulse modulator circuit may comprise a single chip.

When said L connections comprises L output pins (OP1, OPL), an advantageous embodiment of the present invention is obtained.

When said switched output stage (SWOS) is comprised in one single chip, an advantageous embodiment of the present invention is obtained.

The switched output stage may e.g. be comprised in one single chip, which may be advantageous in several different applications where a multi-channel amplifier is applied.

When said switched output stage (SWOS) is distributed in two or more chips, an advantageous embodiment of the present invention is obtained.

When applying a multi-chip or multi-components switched output stage an advantageous embodiment may be obtained with respect to the single switching amplifiers and/or with respect to the arranging of the amplifiers in relation to space, cooling, topology in general, etc. When applying two or more chips, a distribution method must be applied in order to distribute the packed pulse modulated signal to the relevant channel amplifiers of the output stage.

When said pulse modulation is a two-level modulation, a three-level modulation or a higher-level modulation, an advantageous embodiment of the present invention is obtained.

When said multi-channel pulse modulation system comprises a pulse width modulation system comprising a multi-channel pulse width modulator comprised in said pulse modulator circuit.

When said pulse modulation amplifier is an audio converter, an advantageous embodiment of the present invention is obtained.

When at least one of said L-output connections (OP1, OPL) facilitate a bi-directional communication between the modulations circuit (PMC) and said output stage, an advantageous embodiment of the present invention is obtained.

A bi-directional communication established with respect to each output or representation thereof facilitate that information may be fed back from the output stage to the pulse modulator circuit by means of few connections, e.g. pins. Such information may e.g. be the actual switching times of the individual switched channels may be fed back to the modulator circuit, thereby enabling e.g. a desired compensation or modulation established responsive to actual switching times of the individual output channels.

When said pulse modulator circuit (PMC) comprises at least one connection dedicated for receipt of information from the state of the output stage, an advantageous embodiment of the present invention is obtained.

When said output stage comprises a pulse signal splitter (PSS; 124), an advantageous embodiment of the present invention is obtained.

When said pulse signal splitter (PSS; 124) corrects modifications applied in the pulse signal combiner (PSC), an advantageous embodiment of the present invention is obtained.

When correcting modifications applied to the N-channel pulse modulated signal in the pulse signal combiner, errors may be avoided in the final pulse modulated signal of the relevant channel of the output stage.

It should of course be noted that such so-called errors may, according to a preferred embodiment of the invention, relate to deliberate modifications of the N-channel pulse modulated signal in order to avoid simultaneous switching of the channels of the output stage. Such deliberate errors should of course not be corrected.

When the number L of output connections is one, an advantageous embodiment of the present invention is obtained.

According to an embodiment of the invention, an M-channel signal may be output as a single-ended signal. Thus, according to an embodiment of the invention, a one-channel signal may be transmitted by one output connection.

When the number L of output connections is two, an advantageous embodiment of the present invention is obtained.

According to an embodiment of the invention, an M-channel signal may be output as a differential signal.

When at least one of said M-channels are bidirectional, an advantageous embodiment of the present invention is obtained.

The advantage of applying bidirectionality between the pulse modulator circuit and the further switching circuitry is that e.g. switch delay times of the switching stage(s) may vary dynamically and may thereby be evaluated and compensated in the pulse modulator circuit. According to an embodiment of the invention, each of the applied M-channels are directional, thereby optimizing the signal flow between the pulse modulator circuit and the switching stage.

When at least a subset of said M-channels are directed from the pulse modulator circuit (PMC), an advantageous embodiment of the present invention is obtained.

When at least a further subset of said M-channels are directed to the pulse modulator circuit (PMC), an advantageous embodiment of the present invention is obtained.

An advantage of e.g. dedicating one or several channels as return path(s) is that a relatively exhaustive information about the actual switching stage(s) and the general state of these stage(s) may be fed on a runtime basis back to the pulse modulator circuit for monitoring, evaluation and/or compensation purposes.

When said M-channel signal is converted into an N-channel signal and distributed to N-channels of the output stage (AMP1, ..., AMP6) as pulse modulated signals, an advantageous embodiment of the present invention is obtained.

When said N-channel signal distributed to said output stage corresponds to an N-channel signal established by an N-channel pulse modulator (N-PMS) of said pulse modulator circuit (PMC), an advantageous embodiment of the present invention is obtained.

The present invention further relates to a method of converting an N-channel pulse modulated signal into an M-channel signal, where M is less than N,
whereby said converting involves that at least one of said M-channel signals are modified into a nori-coincident pulse modulated signal representing at least a subset of said N-channel pulse modulated signal and where said subset of said N-channel pulse modulated signal comprises at least two channels.

When said converting of said N-channel pulse modulated signal involves an initial establishment of said N-channel pulse signal of non-coincident pulses and whereby said non-coincident pulses subsequently are combined into said M-channel signals, an advantageous embodiment of the present invention is obtained.

### The drawings

The invention will now be described with reference to drawings where
fig. 1 illustrates principles of signal combining and signal splitting according to the invention in pulse modulator multi-channel systems,
fig. 2 illustrates some general principles of the invention,
fig. 3A-3C illustrate different properties of the individual channels of the modulator applied in the specific embodiment of fig. 4A and 4B,
fig. 4A-4B illustrate specific multi-channel embodiments applying the principles of the present invention,
fig. 5A-5B illustrate possible combination signals of the modulator output signals according to an embodiment of the present invention, and where
fig. 6 illustrates a more detailed view of a part of an embodiment of the present invention.

### Detailed description

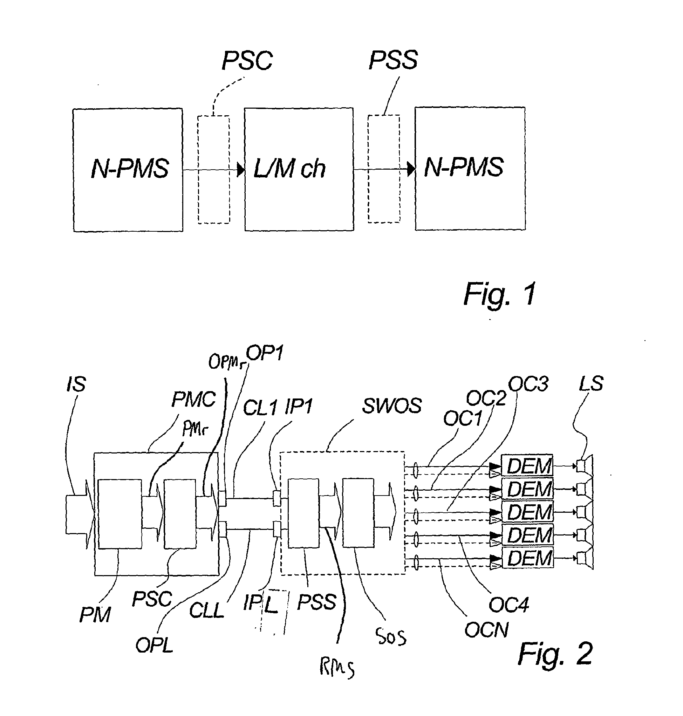

Fig. 1 illustrates principles of signal combining and signal splitting applied in an exemplary N-M-N pulse modulator multi-channel system according to an embodiment of the invention.

According to the invention, an N-channel pulse modulated signal N-PMS, e.g. an N-channel pulse width modulated signal modulated according to conventional pulse width modulation principles is combined into an M-channel signal, preferably analog pulse modulated signal, by means of a pulse signal combiner. The M-channel signal is interfaced from the modulator circuit by means of a number of L connections of the modulator circuit. The modulator may e.g. be comprised in a chip. According to the invention, the number of output connections, e.g. output pins, of e.g. a 6-channel modulator chip may be as low as one.

The M-channel signal may then be transmitted to an output stage and split into an N-channel pulse modulated signal by means of a pulse signal splitter and thereby regenerated as intended and corresponding to the principles applied when the N-channel pulse modulated signal was established in the pulse modulator.

According to a very preferred embodiment of the invention, the N-channel pulse modulated signal should be established as a parallel sequence of N pulse modulated signal streams and where none of the switching times of the complete sequence or at least two of the N channels are coincident. Such a modulation technique facilitates low cross-talk in the multi-channel output stage and a relatively straightforward combining of the N-channels at the modulator side by the pulse signal combiner PSC as all pulses may be merged into one analog signal without conflicts arising from e.g. two coincident pulse trigger signals in two parallel N-channels.

Fig. 2 illustrates some general principles of the invention.

The illustrated pulse modulator system according to the invention comprises a pulse modulator circuit PMC receiving input signals IS. The input signals may have any form and be established internally in the modulator circuit PMC or they may be established by interfacing the pulse modulator circuit with another signal processing circuit. Input signals may comprise a single fast-running stream of data or a parallel stream of data, preferably one input line per channel.

The pulse modulator circuit may e.g. comprise a system of N pulse modulator channels, e.g. six, where the input signal is converted into a corresponding number of streams of pulse modulation representations PMr. The pulse modulator combines the pulse modulation representations PMr into a low number, e.g. one differential coding of all channels of the pulse modulation representations and interfaces the stream via L output connections OP1,..,OPL, e.g. two, of the circuit PMC as an output pulse modulation representation OPMr.

In this way, a multi-channel pulse modulation representation has been established in a small-signal environment and represented as such, and the multi-channel output pulse modulation representations OPMr have been interfaced with the environment by a number of modulator circuit PMC output connections OP1,..,OPL which is lower than the number of channels N.

The output pulse modulation representations OPMr are then interfaced with a multi-channel switched output stage SWOS by means of input connections IP1,..IPL, e.g. pins, via L-communication lines CL1,..CLL. The number of channels of the output stage would typically correspond to the number of channels N of the pulse modulator circuitry PMC. It should in this context be stressed that the invention may apply even with only one communication line as the sole communication line from the modulator to the output stage, although two lines have been shown in the drawing.

The switched output stage may be arranged in one chip or in a multi-chip arrangement as indicated by the dotted lines.

The multi-channel switched output stage SWOS receives the output pulse modulation representations OPMr, and a pulse signal splitter PSS decodes (splits) the signal into N channels of reestablished pulse modulated signals RMS. The N channels of reestablished pulse modulation representations are then fed to switched output stages SOS and output by means of N-output channels OC1, OCN.

In the illustrated embodiments, each of the outputs are fed to demodulators and subsequently fed to loudspeakers LS.

According to a preferred embodiment of the invention, the above described pulse modulator circuit PMC may advantageously comprise a pulse modulator chip comprising a number of output connections preferably constituted by output pin(s).

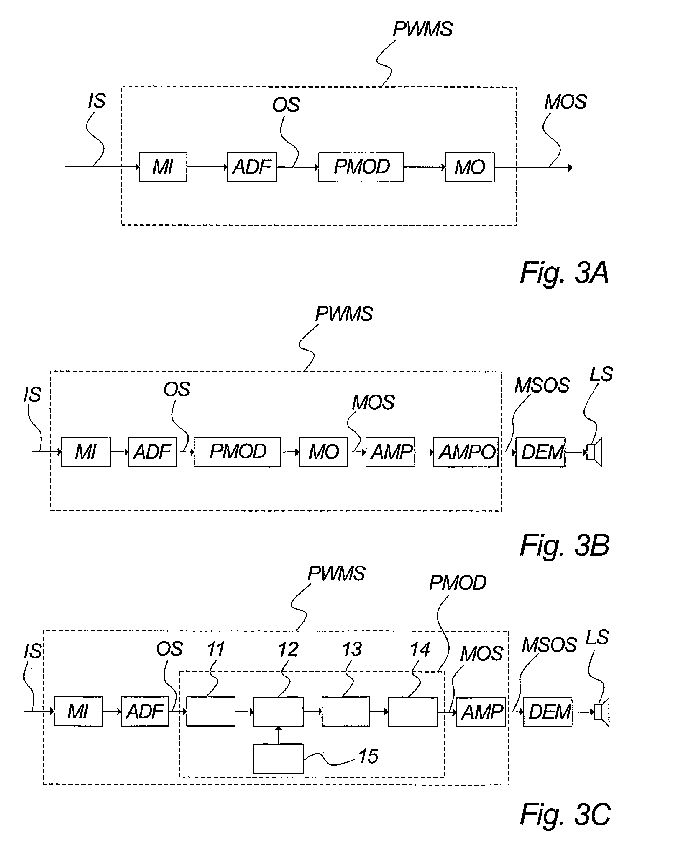

Fig. 3A - 3C illustrate a few out of several different principle topologies of PWM-amplifier system which may find use in a multi-channel system of the invention,

Figure 3A illustrates an embodiment of a pulse width modulator system PWMS of an embodiment of the invention. It comprises a modulator input MI receiving an input signal IS. The input signal is preferably the utility signal to be pulse width modulated. An amplitude distribution filter ADF processes the input signal IS in order to adapt the input signal amplitude distribution to achieve the best performance of subsequent stages. The amplitude distribution filter ADF establishes an output signal OS, also referred to as intermediate output signal, which is fed to a pulse width modulator PMOD. The pulse width modulator PMOD establishes a pulse width modulated representation of the output signal, and outputs it via a modulator output MO as a modulator output signal MOS. It is noted that the illustrated embodiment is merely an example, and that several other pulse width modulator systems are suitable for use with the present invention. In a preferred alternative embodiment, the amplitude distribution filter ADF is, e.g., integrated into the pulse width modulator PMOD in such a way that it would render a simple illustration unclear with respect to the present invention. A preferred embodiment is disclosed in co-pending application PCT/DK2004/000376

Figure 3B illustrates a further embodiment of a pulse width modulator system PWMS of the present invention, and a context for its use. It comprises all elements of figure 1A coupled as described above. It furthermore comprises an amplifier AMP receiving the modulator output MOS. The amplifier is preferably of the power switch type, but may be any amplifier suited for amplifying a PWM-signal. The amplifier may comprise any number of switches and couplings of these, in accordance with the type of PWM-modulation scheme used by the PWM-modulator PMOD. The amplifier outputs a modulator system output signal MSOS via an amplifier output AMPO. The modulator system output signal MSOS being the output of the pulse width modulator system PWMS of the present embodiment is preferably demodulated by means of a demodulator DEM, typically a low-loss, low-pass filter, and is fed to a loudspeaker LS. According to the particular PWM-modulation scheme used, the amplifier, demodulator and loudspeaker may be coupled in any way suitable. This particularly applies for systems where the PWM-signal is distributed over two or more simultaneous signal parts, e.g. as typically used for three level PWM-signals.

Figure 3C illustrates a further embodiment of a pulse width modulator system PWMS of the present invention, and in particular illustrates an example of an embodiment of the pulse width modulator PMOD. The illustrated system comprises a PWM-amplifier/audio system for use with a discrete time input signal, e.g. a pulse code modulated (PCM) signal.

Like the embodiment of figure 1B the present embodiment comprises a modulator system input MI feeding an input signal IS to an amplitude distribution filter ADF. The intermediate output signal OS of the amplitude distribution filter ADF is fed to the pulse width modulator PMOD.

The modulator output MOS of the pulse width modulator PMOD, i.e. a pulse width modulated signal, is amplified by means of an amplifier AMP as described above and rendered into sound by means of a demodulator DEM and a loudspeaker setup LS as also described above.

Figure 3C further illustrates an embodiment of a pulse width modulator PMOD. It comprises an upsampling block 11 basically transforming the intermediate output signal OS from one sampling frequency representation into an N times higher sampling representation.

The upsampled signal is then fed to an intersection-computing block 12 adapted for determination of intersections with a parallel reference signal representation 16 provided by a reference signal generator 15. The intersections may e.g. be established in the block 12 according to the principles disclosed in PCT/DK03/00334 or in PCT/DK2004/000361. A consecutive noise shaping and quantizing block 13 feeds the established intersections to a pulse generator 14 which establishes the modulator output signal MOS, i.e. a pulse width modulated signal. In an alternative embodiment the amplitude distribution filter ADF, or parts of it, may be integrated with the noise shaping and quantizing block 13 of the pulse width modulator PMOD.

It is noted that the above-described embodiment of a pulse width modulator PMOD is only one of several possible embodiments suitable for use with the present invention. Also several different kinds of pulse width modulation and encoding schemes may be used for establishing the pulse width modulated signal MOS. This signal may thus perfectly be distributed over several sub-signals, e.g. when differential PWM-signals are established. In such cases also the amplifier AMP may comprise several sub-amplifiers, typically power switches, and the demodulator DEM may comprise several demodulators. Also the loudspeaker setup may comprise several signal inputs.

An example of a further pulse width modulator PMOD embodiment that may be used with the present invention is disclosed in PCT/DK03/00475.

A further example of a pulse width modulator PMOD embodiment that may be used with the present invention is disclosed in EP 1 178 388 A1.

It is noted that the above-mentioned embodiment examples are not exhaustive, and that the present invention may be used in any context for any application and that the illustrations in figure 3A, 3B and 3C are only examples for establishing a concept and context for the following detailed description.

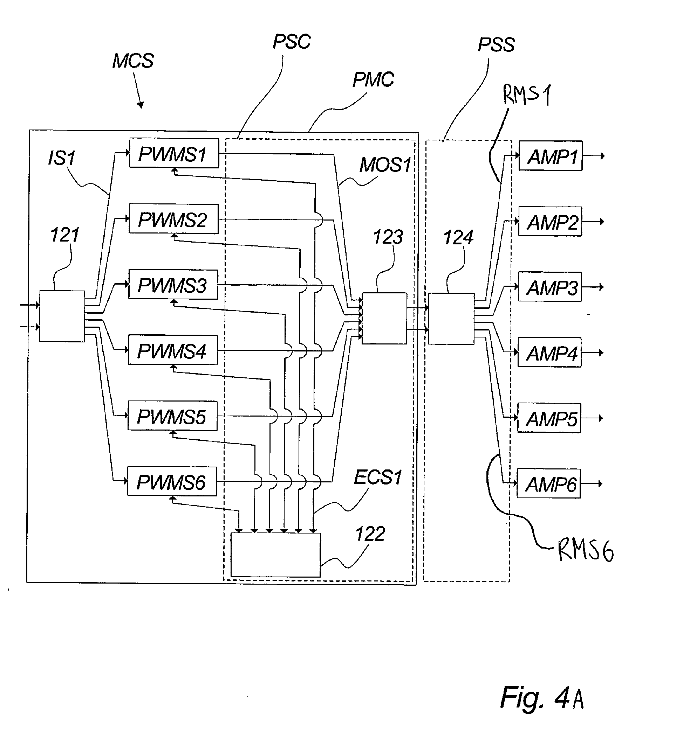

It is noted, with reference to the below explanation of fig. 4A that a modification of the fig. 3B and 3C has to be made in order to apply the principles of the invention in a multi-channel system. Thus, when using e.g. N of the illustrated systems in parallel in a multi-channel amplifier setup, modulator output signals MOS of the pulse width modulator system of e.g. fig. 3B or fig. 3C are merged or combined within the modulator chip to e.g. two communication lines and interfaced to the switched output stage, e.g. a chip.

Fig. 4A illustrates a principle embodiment of the invention.

An example of an application where dynamically positioned problematic amplitude ranges may be advantageously utilized is given in figure 4A.

More details about the specific embodiment are given in the co-pending PCT/DK2004/000376 This application basically addresses the need for counteracting undesired side effects due to limited slew rate when outputting narrow pulses, resulting in a distortion of the pulse established by the output stage. Such counteracting, i.e. the method and means described in detail in PCT/DK2004/000376, may be applied advantageously together with the principles of the present invention in a multi-channel output stage as a modification of the signal fed to the switching stage may advantageously by applied to minimize cross-talk in the output stage by minimizing or removing switching at the same time. Such compensation requires a mutual control or interaction, as the switching or the intended switching of one channel may result in a modified switching of another channel.

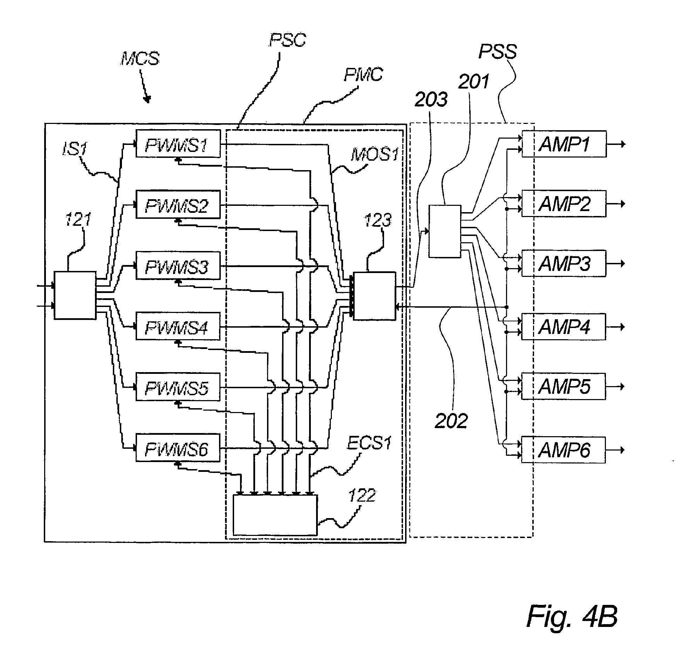

It comprises an embodiment of a multi-channel PWM modulator system MCS embodied in a pulse modulator chip PMC. Such a system may e.g. be used for pulse width modulating several audio channels, e.g. 6 channels, and may advantageously be implemented in a single integrated circuit. One of several issues to consider when implementing a system in an integrated circuit is the use of output connectors, here output pins, as the number of these significantly impacts the cost of the integrated circuit, i.e. production and materials. A possible solution to this problem is to combine the multiple audio channels into a fewer number of physical conductors. When e.g. the system comprises 6 audio channels it may be possible by means of a proper multiplexing algorithm, compression algorithm, etc., to combine the information of these into e.g. 2 or 4 physical wires. In figure 4 is shown two signals entering the multi-channel PWM modulator system MCS. These signals may each require more than one physical connector, but use together preferably less than 6 connectors. Within the multi-channel system MCS the combined channels signal is split into a signal for each of the 6 individual channels by a signal splitter 121. Alternatively, each of the 6 channels may enter the multi-channel system MCS by its own physical connector. Each of the 6 channels are provided to a pulse width modulating system PWMS1, PWMS2, ..., PWMS6 as input signals, whereof due to clarity in the drawing only a reference IS1 is given for the first channel. The modulator output signals MOS1, etc., which are pulse width modulated representations for the input signal IS1, etc. are again combined into less than 6 physically wired signals by means of a signal combiner 123.

Figure 4A further comprises a signal splitter 124 for dividing the combined modulator output signal into a reestablished pulse modulation signal RMS1, ..., RMS6 for each channel outside the integrated circuit comprising the multi-channel pulse width modulator system MCS. The signal splitter 124 forms part of a pulse signal splitter PSS as described and explained with reference to fig. 2. Each of these pulse width modulated output channels may then be fed to, e.g., separate amplifiers AMP1, ..., AMP6, preferably switch-mode amplifiers. Alternatively the combined modulator output signal may be fed directly to each of the subsequent, e.g. amplifiers, by bypassing the signal splitter 124. The subsequent stage, e.g. amplifier, should then be adapted to retrieve from the combined signal only the relevant channel.

In order to most optimally combine multiple pulse width modulated signals MOS1, etc., into a fewer physical signals by means of signal combiner 123, it may be beneficial to assume that none of the PWM-signals comprise concurrent pulse flanks. As the input signal amplitudes determine the pulse widths, and thus the flanks of the pulses, non-concurrent pulse flanks may be ensured by ensuring that a pulse width modulator PMOD of one pulse width modulator system PWMS1, ..., PWM6 never receives the same intermediate output signal OS amplitude at the same time as the modulator of another system PWMS1, ..., PWMS6, as this would probably cause concurrent pulse flanks to be established.

A further reason for desiring non-concurrent pulse flanks is the probability of establishing cross-talk when, e.g., the amplifiers AMP1, ..., AMP6 are operated from the same power supply. By ensuring that the switches in different amplifiers are never required to switch simultaneously, the problem of cross-talk may be reduced.

Guaranteeing or at least increasing the probability of non-concurrent flanks in a multi-channel system, e.g. a stereo system or a 5.1 system, is thus desired, and one way in which this may be ensured is, within the example embodiment of figure 4A, by dynamically adapting the problematic amplitude ranges of some of the pulse width modulator systems PWMS1, ..., PWMS6 according to the intermediate output signal amplitudes of other pulse width modulator systems PWMS1, ..., PWMS6.

Such dynamically adapting of the problematic amplitude ranges may e.g. be performed by a pulse amplitude distribution manager 122 connected with each pulse width modulator system PWMS 1, ..., PWMS6 by means of two-way external control signals ECS1, etc. Thereby the pulse amplitude distribution manager 122 may continuously obtain information of the currently processed input values or intermediate output values, and adaptively establish control information accordingly. Within each pulse width modulator system PWMS1, ..., PWMS6 an amplitude distribution filter ADF as mentioned above, or other suitable means, may communicate with the pulse amplitude distribution manager 122 and on the basis of the relevant input signal IS 1 and external control signal ECS1 cause establishment of non-concurrent flanks.

The signal combiner 123 and the pulse amplitude distribution manager 122 thus forms a pulse signal combiner PSC as described and explained with reference to fig. 2.

Evidently, the invention may be applied in several other technical concepts than the above-described.

Figure 4B illustrates an alternative embodiment of an application as described regarding figure 4A. Figure 4B also comprises a multi-channel pulse modulator system MCS as described above. The multi-channel pulse modulator system also comprises a pulse signal combiner PSC comprising a pulse amplitude distribution manager 122 and a signal combiner 123. The signal combiner 123 of figure 4B establishes a data signal 202 and a channel code signal 203 on the basis of the, e.g., six modulator output signals MOS1, ..., MOS6. Figure 4B further comprises a pulse signal splitter PSS, which comprises a decoder 201 and parts of the output stages AMP1,..., AMP6. The data signal 202 comprises a compressed representation of the switching times for all channels, and is preferably transferred by means of a single wire. The data signal 202 is connected to all output stages AMP1, ..., AMP6, which preferably comprise latches, e.g. flip-flops, in order to be able to read the data signal 202. The channel code signal 203 may, e.g., be a 3-bit signal transferred over 3 wires, and thus able to address up to 8 channels by binary representation. For every switching time comprised by the data signal 202, the channel code signal 203 preferably comprises a pointer to the channel to which the switching time correspond. The decoder 201 decodes the channel code signal 203 and is on this basis able to enable the latch of the corresponding output stage.

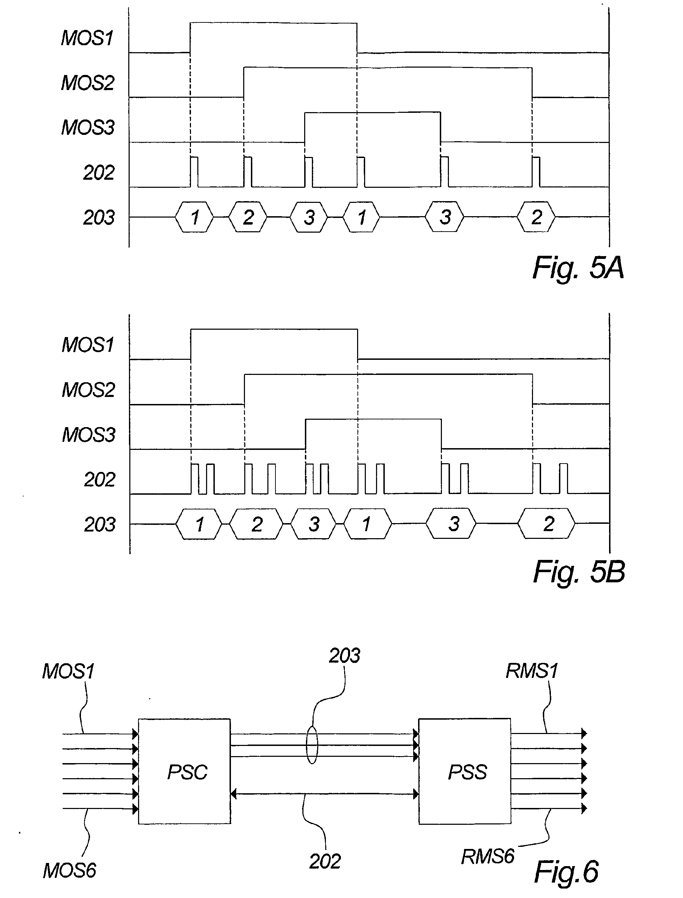

Figure 5A comprises a timing diagram illustrating possible signal contents in order to clarify how the above-described mechanism may work. Figure 5A comprises the modulator output signal MOS1, MOS2, MOS3, of three of the channels of figure 4B. Each signal comprises a PWM pulse, but with no simultaneous edges. Figure 5A further comprises the data signal 202, i.e. a compressed representation of the modulator output signals MOS1, MOS2, MOS3. Each pulse in the data signal 202 represents an edge, either rising or falling. The width of each pulse in the data signal 202 is preferably as short as possible while still wide enough to be detected by the latches of the output stages. As there are no simultaneous edges, there is no problem in combining the edges of the modulator output signals into a single data signal. In order for the output stages to know which of the data signal pulses correspond to which channels, a channel code signal 203 is establish in correlation with the data signal 202. A possible channel code signal 203 is shown in figure 5A. In a period from a little before each pulse of the data signal 202 it is set to a binary value representing the respective channel. Via the decoder 201 this causes the latch of the output stage corresponding to that channel to be enabled in time for reading the pulse of the data signal 202.

In figure 4B the data signal 202 is shown as a bi-directional signal. In addition to the working mode describe above, the data signal 202 may also be used for transmitting feedback from the output stage AMP1, ..., AMP6 to the pulse modulator circuit PMC. Such feedback may, e.g., comprise the actual switch times established by the output stages. As the output stages typically comprise not only a fixed delay but also varying delays, e.g. dependent on the input signal, such information may be used for further pre-correction or compensation within the pulse modulator circuit PMC. Other possible feedback may comprise information about the state of the output stages, e.g. if an output stage is in an illegal state, or otherwise malfunctioning, or information about variations in the power supply voltage provided to switching output stages. As the output stage delay is typically longer than the necessary width of the data signal pulses, the feedback may be established on the data signal wire during the period between the end of a switch time representing pulse and until the next switch time representing pulse. Such a data signal 202 comprising feedback is illustrated in figure 5B. When the signal combiner 123 has established a switch time representing pulse for some channel it doesn't use the data signal wire until the next switch time representing pulse has to be established. In the intervening time the output stage may use the wire for feedback purposes. The available feedback time slot may be pre-defined, or, e.g., controlled by the channel code signal, a further clock signal, or any other suitable signal. In case of using the feedback feature, the pulse modulator circuit PMC should evidently comprise a circuitry for receiving, interpreting and using the feedback. This may, e.g., be implemented by the pulse amplitude distribution manager 122. For feedback interpretation purposes the channel code 203 or a separate control signal may further be provided to the pulse modulator circuit PMC.

The data signal 202 may comprise adjusted switch time representations or reference switch time representations. In the first case the pulse modulator circuit PMC comprises correcting and compensation logic for attempting to correct the errors in the output stages. In the latter case the pulse modulator circuit PMC merely transmits the correct reference switch time representations, and lets the output stages correct or compensate their own errors. In such case the output stages may comprise local, analog feedback. Thereby, e.g., power supply errors or variations may be compensated. In a further embodiment a combination is applied, where local, analog feedback in the output stages establish error information, which may be fed back to the pulse modulator circuit PMC by means of the data signal 202 or a separate signal.

Figure 6 illustrates a detailed view of an embodiment of the connection between a pulse signal combiner PSC and a pulse signal splitter PSS according to the present invention. The pulse signal combiner PSC comprises N inputs, MOS1, ..., MOS6, also referred to as output pulse modulation representations OPMr. In the present embodiment N is six. Each input represents an input channel of a pulse modulator system PMC, e.g. audio channels. The pulse signal combiner PSC establishes an M-channel communication signal 202, 203, which is transmitted to the pulse signal splitter PSS by means of L output connections. In the embodiment of figure 6 M is two as it, e.g., comprises a data signal 202 and a channel code 203. As the channel code in the present embodiment uses 3 wires, L is 4 in the present embodiment. The pulse signal splitter PSS establishes a number of output channels RMS1, ..., RMS6, preferably corresponding to the N input channels.

It is noted that the embodiment of figure 6 is an example, and that any values of N, M and L are within the present invention, as long as N is greater than L, i.e. the communication between the pulse signal combiner PSC and pulse signal splitter PSS uses less connections from the pulse modulator circuit PMC than the number of channel processed by the multi-channel pulse modulator system MCS.

Hence connections between the signal combiner and signal splitter may be uni- or bidirectional, may be a multilevel signals, may comprise any number of connections less than N, including 1 connection, may utilize any communication protocol and data transfer technology, etc. Thus, in an alternative embodiment only one wire connects the pulse modulator circuit PMC and the pulse signal splitter PSS, that wire comprising a multilevel signal where, e.g., the signal level is used for transmitting the channel code information.

## Claims

1. A multi-channel pulse modulator system comprising a pulse modulator circuit (PMC),
wherein said pulse modulator circuit (PMC) comprises an N-channel pulse width modulator (PWMS1, PWMS2,..PWMS6) for modulating an N-channel input signal,
wherein the modulator output is multiplexed and output from the pulse modulator circuit (PMC) by means of L output connections (OP1, OPL) of the pulse modulator circuit (PMC) and where L is less than the number of modulator channels N.

2. . A multi-channel pulse modulator system according to claim 1, wherein said multi-channel pulse modulator system further comprises a switched output stage (SWOS),
wherein said pulse modulator circuit (PMC) comprises an N-channel pulse width modulator (PWM1, PWMS2,..PWMS6; PM),
wherein the modulator output is interfaced from the pulse modulator circuit (PMC) to the switching output stage (SWOS) by means of L output connections, e.g. output pins (OP1, OPL), of the modulator circuit (PMC) and where L is less than the number of modulator channels N.

3. A multi-channel pulse modulator system according to claim 1 or 2, wherein the L output connections (OP1, OPL) outputs an M-channel signal where M is less than N,
wherein said M-channel signal is established by a pulse signal combiner (PSC),
wherein said pulse signal combiner (FSC) combines at least one of said M-channel signals into a non-coincident pulse modulated signal (202, 203) representing at least a subset of an N-channel pulse modulated signal established by said N-channel pulse width modulator (PWMS1, PWMS2, PWMS61, PM),

4. A multi-channel pulse modulator system according to any of the claims 2 to 3, wherein the number of output channels (OC1, OC2, OC3, OCN) of the switching output stage (SWOS) is N.

5. A multi-channel pulse modulator system according to any of the claims 3 to 4, wherein said pulse signal combiner (PSC) combines said N-channel pulse modulated signal by an initial establishment of said N-channel pulse signal of non-coincident pulses and whereby said non-coincident pulses subsequently are combined into said M-channel signal.

6. A multi-channel pulse modulator system according to any of the claims 3 to 5, whereby said M-channel output comprises a sequence of analog pulses, and whereby said sequence of analog pulses defines the pulses of an N-channel pulse modulated signal,

7. A multi-channel pulse modulator system according to any of the claims 1 to 6, wherein said pulse modulator circuit comprises a pulse modulator chip (PMC).

8. A multi-channel pulse modulator system according to any of the claims 1 to 7, wherein said L connections comprises L output pins (OP1, OPL).

9. A multi-channel pulse modulator system according to any of the claims 2 to 8, wherein said switched output stage (SWOS) is comprised in one single chip.

10. A multi-channel pulse modulator system according to any of the claims 2 to 9, wherein said switched output stage (SWOS) is distributed in two or more chips.

11. A multi-channel pulse modulator system according to any of the claims 1 to 10, wherein said pulse modulation is a two-level modulation, a three-level modulation or a higher-level modulation.

12. A multi-channel pulses modulator system according to any of the claims 1 to 11, wherein said multi-channel pulse modulator system comprises a pulse width modulation system comprising a multi-channel pulse width modulator comprised in said pulse modulator circuit

13. A multi-channel pulse modulator system according to any of the claims 1 to 12, wherein said pulse modulator system is an audio converter

14. A multi-channel pulse modulator system according to any of the claims 2 to 13, wherein at least one of said L-output connections (OP1, OPL) facilitate a bidirectional communication between the modulation circuit (PMC) and said output stage.

15. A multi-channel pulse modulator system according to any of the claims 2 to 14, wherein said pulse modulator circuit (PMC) comprises at least one connection dedicated for receipt of information from the state of the output stage.

16. . A multi-channel pulse modulator system according to any of the claims 2 to 15, wherein said output stage comprises a pulse signal splitter (PSS; 124).

17. . A multi-channel pulse modulator system according to claim 16, wherein said pulse signal splitter (PSS; 124) corrects modifications applied in the pulse signal combiner (PSC).

18. . A multi-channel pulse modulator system according to any of the claims 1 to 17, whereby the number L of output connections is one.

19. . A multi-channel pulse modulator system according to any of the claims 1 to 18, whereby the number L of output connections is two.

20. . A multi-channel pulse modulator system according to any of the claims 3 to 19, whereby at least one of said M-channels are bidirectional.

21. . A multi-channel pulse modulator system according to any of the claims 3 to 20, whereby at least a subset of said M-channels are directed from the pulse modulator circuit (PMC).

22. . A multi-channel pulse modulator system according to any of the claims 3 to 21, whereby at least a further subset of said M-channels are directed to the pulse modulator circuit (PMC).

23. . A multi-channel pulse modulator system according to any of the claims 3 to 22, wherein said M-channel signal is converted into an N-channel signal and distributed to N-channels of the output stage (AMP1,..., AMP6) as pulse modulated signals.

24. . A multi-channel pulse modulator system according claim 23, wherein said N-channel signal distributed to said output stage corresponds to an N-channel signal established by an N-channel pulse width modulator (N-PMS) of said pulse modulator circuit (PMC).

25. . Method of converting an N-channel pulse width modulated signal established from an N-channel input signal into an M-channel signal, where M is less than N,
whereby said converting involves that at least one of said M-channel signals are modified into a non-coincident pulse modulated signal representing at least a subset of said N-channel pulse width modulated signal and where said subset of said N-channel pulse width modulated signal comprises at least two channels.

26. . Method of converting an N-channel pulse width modulated signal into an M-channel signal according to claim 25, whereby said converting of said N-channel pulse width modulated signal involves an initial establishment of said N-channel pulse width modulated signal of non-coincident pulses and whereby said non-coincident pulses subsequently are combined into said M-channel signals.

## Patentansprüche

1. Mehrkanaliges Pulsmodulatorsystem, welches eine Pulsmodulatorschaltung (PMC) umfasst,
wobei die Pulsmodulatorschaltung (PMC) einen N-kanaligen Pulsweitenmodulator (PWMS1, PWMS2,..PWMS6) zum Modulieren eines N-kanaligen Eingangssignals umfasst,
wobei der Modulatorausgang gemultiplext und aus der Pulsmodulatorschaltung (PMC) mittels L Ausgangsverbindungen (OP1, OPL) der Pulsmodulatorschaltung (PMC) ausgegeben wird, und wobei L kleiner als die Anzahl von Modulatorkanälen N ist.

2. Mehrkanaliges Pulsmodulatorsystem gemäß Anspruch 1, wobei das mehrkanalige Pulsmodulatorsystem ferner eine geschaltete Ausgangsstufe (SWOS) umfasst,
wobei die Pulsmodulatorschaltung (PMC) einen N-kanaligen Pulsweitenmodulator (PWMS1, PWMS2,..PWMS6; PM) umfasst,
wobei der Modulatorausgang von der Pulsmodulatorschaltung (PMC) an die Schaltausgarigsstufe (SWOS) mittels L Ausgangsverbindungen, z.B. Ausgangsstifte (OP1, OPL), der Modulatorschaltung (PMC) angeschlossen ist, und wobei L kleiner als die Anzahl von Modulatorkanälen N ist.

3. Mehrkanaliges Pulsmodulatorsystem gemäß Anspruch 1 oder 2, wobei die L Ausgangsverbindungen (OP1, OPL) ein M-kanaliges Signal ausgeben, wobei M kleiner als N ist,
wobei das M-kanalige Signal mittels eines Pulssignalkombinierers (PSC) gebildet wird,
wobei der Pulssignalkombinierer (PSC) wenigstens eines der M-kanaligen Signale zu einem nicht-zusammenfallenden pulsmodulierten Signal (202, 203) kombiniert, das wenigstens eine Untermenge eines N-kanaligen pulsmodulierten Signal darstellt, das von dem N-kanaligen Pulsweitenmodulator (PWMS1, PWMS2,..PWMS6; PM) gebildet wird.

4. Mehrkanaliges Pulsmodulatorsystem gemäß einem der Ansprüche 2 bis 3, wobei die Anzahl von Ausgangskanälen (OC1, OC2, OC3,.. OCN) der Schaltausgangsstufe (SWOS) N ist.

5. Mehrkanaliges Pulsmodulatorsystem gemäß einem der Ansprüche 3 bis 4, wobei der Pulssignalkombinierer (PSC) das N-kanalige pulsmodulierte Signal durch eine anfängliche Bildung des N-kanaligen Pulssignals von nicht-zusammenfallenden Pulsen kombiniert, und wobei die nicht-zusammenfallenden Pulse anschließend zu dem M-kanaligen Signal kombiniert werden.

6. Mehrkanaliges Pulsmodulatorsystem gemäß einem der Ansprüche 3 bis 5, wobei die M-kanalige Ausgabe eine Folge von analogen Pulsen umfasst, und wobei die Sequenz von analogen Pulsen die Pulse eines N-kanaligen pulsmodulierten Signals festlegt.

7. Mehrkanaliges Pulsmodulatorsystem gemäß einem der Ansprüche 1 bis 6, wobei die Pulsmodulatorschaltung einen Pulsmodulatorchip (PMC) umfasst.

8. Mehrkanaliges Pulsmodulatorsystem gemäß einem der Ansprüche 1 bis 7, wobei die L Verbindungen L Ausgangsstifte (OP1, OPL) umfassen.

9. Mehrkanaliges Pulsmodulatorsystem gemäß einem der Ansprüche 2 bis 8, wobei die geschaltete Ausgangsstufe (SWOS) in einem einzigen Chip umfasst ist.

10. Mehrkanaliges Pulsmodulatorsystem gemäß einem der Ansprüche 2 bis 9, wobei die geschaltete Ausgangsstufe (SWOS) in zwei oder mehr Chips verteilt ist.

11. Mehrkanaliges Pulsmodulatorsystem gemäß einem der Ansprüche 1 bis 10, wobei die Pulsmodulation eine zweistufige Modulation, eine dreistufige Modulation oder eine höherstufige Modulation ist.

12. Mehrkanaliges Pulsmodulatorsystem gemäß einem der Ansprüche 1 bis 11, wobei das mehrkanalige Pulsmodulatorsystem ein Pulsweitenmodulationssystem umfasst, das einen mehrkanaligen Pulsweitenmodulator umfasst, der in der Pulsmodulatorschaltung umfasst ist.

13. Mehrkanaliges Pulsmodulatorsystem gemäß einem der Ansprüche 1 bis 12, wobei das Pulsmodulatorsystem ein Audio-Wandler ist,

14. Mehrkanaliges Pulsmodulatorsystem gemäß den Ansprüchen 2 bis 13, wobei wenigstens eine der L Ausgangsverbindungen (OP1, OPL) eine bidirektionale Kommunikation zwischen der Modulationsschaltung (PMC) und der Ausgangsstufe erleichtert.

15. Mehrkanaliges Pulsmodulatorsystem gemäß einem der Ansprüche 2 bis 14, wobei die Pulsmodulatorschaltung (PMC) wenigstens eine Verbindung umfasst, die zum Empfang von Information vom Zustand der Ausgangsstufe bestimmt ist.

16. Mehrkanaliges Pulsmodulatorsystem gemäß einem der Ansprüche 2 bis 15, wobei die Ausgangsstufe einen Pulssignalsplitter (PSS; 124) umfasst.

17. Mehrkanaliges Pulsmodulatorsystem gemäß Anspruch 16, wobei der Pulssignalsplitter (PSS; 124) im Pulssignalkombinierer (PSC) eingesetzte Modifikationen korrigiert.

18. Mehrkanaliges Pulsmodulatorsystem gemäß einem der Ansprüche 1 bis 17, wobei die Anzahl L von Ausgangsverbindungen eins ist.

19. Mehrkanaliges Pulsmodulatorsystem gemäß einem der Ansprüche 1 bis 18, wobei die Anzahl L von Ausgangsverbindungen zwei ist.

20. Mehrkanaliges Pulsmodulatorsystem gemäß einem der Ansprüche 3 bis 19, wobei wenigstens einer der M Kanäle bidirektional ist.

21. Mehrkanaliges Pulsmodulatorsystem gemäß einem der Ansprüche 3 bis 20, wobei wenigstens eine Untermenge der M Kanäle von der Pulsmodulatorschaltung (PMC) weg gerichtet sind.

22. Mehrkanaliges Pulsmodulatorsystem gemäß einem der Ansprüche 3 bis 21, wobei wenigstens eine weitere Untermenge der M Kanäle zur Pulsmodulatorschaltung (PMC) hin gerichtet sind.

23. Mehrkanaliges Pulsmodulatorsystem gemäß einem der Ansprüche 3 bis 22, wobei das M-kanalige Signal in ein N-kanaliges Signal gewandelt wird und auf N Kanäle der Ausgangsstufe (AMP1,...,AMP6) als pulsmodulierte Signale verteilt werden.

24. Mehrkanaliges Pulsmodulatorsystem gemäß Anspruch 23, wobei das auf die Ausgangsstufe verteilte Kanalsignal einem N-kanaligen Signal entspricht, das von einem N-kanaligen Pulsweitenmodulator (N-PMS) der Pulsmodulatorschaltung (PMC) gebildet wird.

25. Verfahren zum Wandeln eines N-kanaligen pulsweitenmodulierten Signals, das aus einem N-kanaligen Eingangssignal gebildet wird, in ein M-kanaliges Signal, wobei M kleiner als N ist,
wobei das Wandeln umfasst, dass wenigstens eines der M-kanaligen Signale in ein nicht-zusammenfallendes pulsmoduliertes Signal verändert wird, das wenigstens eine Untermenge des N-kanaligen pulsweitenmodulierten Signals darstellt und wobei die Untermenge der N-kanaligen pulsweitenmodulierten Signale wenigstens zwei Kanäle umfasst.

26. Verfahren zum Wandeln eines N-kanaligen pulsweitenmodulierten Signals in ein M-kanaliges Signal gemäß Anspruch 25, wobei das Wandeln des N-kanaligen pulsweitenmodulierten Signals eine anfängliche Bildung des N-kanaligen pulsweitenmodulierten Signals von nicht-zusammenfallenden Pulsen umfasst, und wobei die nicht-zusammenfallenden Pulse anschließend zu den M-kanaligen Signalen kombiniert werden.

## Revendications

1. Système modulateur d'impulsions multicanaux comprenant un circuit modulateur d'impulsions (PMC),
dans lequel ledit circuit modulateur d'impulsions. (PMC) comprend un modulateur de largeur d'impulsion à N canaux (PWMS1, PWM2, ... PWMS6) pour moduler un signal d'entrée à N canaux,
dans lequel la sortie de modulateur est multiplexée et délivrée en sortie par le circuit modulateur d'impulsions (PMC) au moyen de L connexions de sortie (OP1, OPL) du circuit modulateur d'impulsions (PMC) et où L est inférieur au nombre de canaux de modulateur N.

2. Système modulateur d'impulsions multicanaux selon la revendication 1, dans lequel ledit système modulateur d'impulsions multicanaux comprend en outre un étage de sortie à commutation (SWOS),
dans lequel ledit circuit modulateur d'impulsions (PMC) comprend un modulateur de largeur d'impulsion à N canaux (PWMS1, PWMS2, ... PWMS6 ; PM),
dans lequel la sortie de modulateur est interfacée du circuit modulateur d'impulsions (PMC) à l'étage de sortie à commutation (SWOS) au moyen de L connexions de sortie, par exemple des broches de sortie (OP1, OPL), du circuit modulateur d'impulsions (PMC) et où L est inférieur au nombre de canaux de modulateur N.

3. Système modulateur d'impulsions multicanaux selon la revendication 1 ou 2, dans lequel les L connexions de sortie (OP1, OPL) délivrent en sortie un signal à M canaux où M est inférieur à N,
dans lequel ledit signal à M canaux est établi par un combinateur de signaux à impulsions (PSC),
dans lequel ledit combinateur de signaux à impulsions (PSC) combine au moins un des signaux à M canaux en un signal modulé par impulsions non coïncidentes (202, 203) représentant au moins un sous-ensemble d'un signal modulé par impulsions à N canaux établi par ledit modulateur de largeur d'impulsion à N canaux (PWMS1, PWMS2, ... PWMS6 ; PM).

4. Système modulateur d'impulsions multicanaux selon l'une quelconque des revendications 2 à 3, dans lequel le nombre de canaux de sortie (OC1, OC2, OC3, ... OCN) de l'étage de sortie à commutation (SWOS) est N.

5. Système modulateur d'impulsions multicanaux selon l'une quelconque des revendications 3 à 4, dans lequel ledit combinateur de signaux d'impulsions (PSC) combine ledit signal modulé par impulsions à N canaux par un établissement initial dudit signal d'impulsions à N canaux d'impulsions non coïncidentes et où lesdites impulsions non coïncidentes sont successivement combinées dans ledit signal à M canaux.

6. Système modulateur d'impulsions multicanaux selon l'une quelconque des revendications 3 à 5, dans lequel la dite sortie à M canaux comprend une séquence d'impulsions analogiques et où ladite séquence d'impulsions analogiques définit les impulsions d'un signal modulé par impulsions à N canaux.

7. Système modulateur d'impulsions multicanaux selon l'une quelconque des revendications 1 à 6, dans lequel ledit circuit modulateur d'impulsions comprend une puce de modulateur d'impulsions (PMC).

8. Système modulateur d'impulsions multicanaux selon l'une quelconque des revendications 1 à 7, dans lequel lesdites L connexions comprennent L broches de sortie (OP1, OPL).

9. Système modulateur d'impulsions multicanaux selon l'une quelconque des revendications 2 à 8, dans lequel ledit étage de sortie à commutation (SWOS) est composé d'une unique puce.

10. Système modulateur d'impulsions multicanaux selon l'une quelconque des revendications 2 à 9, dans lequel ledit étage de sortie à commutation (SWOS) est distribué dans au moins deux puces.

11. Système modulateur d'impulsions multicanaux selon l'une quelconque des revendications 1 à 10, dans lequel ladite modulation par impulsions est une modulation de niveau deux, une modulation de niveau trois ou une modulation de niveau supérieur.

12. Système modulateur d'impulsions multicanaux selon l'une quelconque des revendications 1 à 11, dans lequel ledit système modulateur d'impulsions multicanaux comprend un système de modulation de largeur d'impulsion comprenant un modulateur de largeur d'impulsion multicanaux compris dans ledit circuit modulateur d'impulsions.

13. Système modulateur d'impulsions multicanaux selon l'une quelconque des revendications 1 à 12, dans lequel ledit système modulateur d'impulsions est un convertisseur audio.

14. Système modulateur d'impulsions multicanaux selon l'une quelconque des revendications 2 à 13, dans lequel au moins une desdites connexions de L sorties (OP1, OPL) facilite une communication bidirectionnelle entre le circuit de modulation (PMC) et ledit étage de sortie.

15. Système modulateur d'impulsions multicanaux selon l'une quelconque des revendications 2 à 14, dans lequel ledit circuit modulateur d'impulsions (PMC) comprend au moins une connexion dédiée pour la réception d'informations à partir de l'état de l'étage de sortie.

16. Système modulateur d'impulsions multicanaux selon l'une quelconque des revendications 2 à 15, dans lequel ledit étage de sortie comprend un séparateur de signal d'impulsions (PSS ; 124).

17. Système modulateur d'impulsions multicanaux selon la revendication 16, dans lequel ledit séparateur de signal d'impulsions (PSS ; 124) corrige des modifications appliquées dans le combinateur de signaux d'impulsions (PSC).

18. Système modulateur d'impulsions multicanaux selon l'une quelconque des revendications 1 à 17, dans lequel le nombre L de connexions de sortie est un.

19. Système modulateur d'impulsions multicanaux selon l'une quelconque des revendications 1 à 18, dans lequel le nombre L de connexions de sortie est deux.

20. Système modulateur d'impulsions multicanaux selon l'une quelconque des revendications 3 à 19, dans lequel au moins un desdits M signaux est bidirectionnel.

21. Système modulateur d'impulsions multicanaux selon l'une quelconque des revendications 3 à 20, dans lequel au moins un sous-ensemble desdits M canaux est dirigé à partir du circuit modulateur d'impulsions (PMC).

22. Système modulateur d'impulsions multicanaux selon l'une quelconque des revendications 3 à 21, dans lequel au moins un autre sous-ensemble desdits M canaux est dirigé vers le circuit modulateur d'impulsions (PMC).

23. Système modulateur d'impulsions multicanaux selon l'une quelconque des revendications 3 à 22, dans lequel ledit signal à M canaux est converti en un signal à N canaux et distribué sur N canaux de l'étage de sortie (AMP1, ..., AMP6) comme des signaux modulés par impulsion.

24. Système modulateur d'impulsions multicanaux selon la revendication 23, dans lequel chaque signal à N canaux distribué sur ledit étage de sortie correspond à un signal à N canaux établi par un modulateur de largeur d'impulsion à N canaux (N-PMS) dudit circuit modulateur d'impulsions (PMC).

25. Procédé de conversion d'un signal modulé en largeur d'impulsion à N canaux établi à partir d'un signal d'entrée à N canaux en un signal à M canaux, où M est inférieur à N,
moyennant quoi ladite conversion implique qu'au moins un desdits signaux à M canaux soit modifié en un signal modulé par impulsions non coïncidentes représentant au moins un sous-ensemble dudit signal modulé par impulsions à N canaux et où ledit sous-ensemble dudit signal modulé par impulsions à N canaux comprend au moins deux canaux.

26. Procédé de conversion d'un signal modulé en largeur d'impulsion à N canaux en un signal à M canaux selon la revendication 25, dans lequel ladite conversion dudit signal modulé en largeur d'impulsion à N canaux implique un établissement initial dudit signal modulé en largeur d'impulsion à N canaux d'impulsions non coïncidentes et où lesdites impulsions non coïncidentes sont successivement combinées dans ledit signal à M canaux.
